(19) Europäisches Patentamt
European Patent Office
Office européen des brevets

(11) EP 0 875 985 A2

(12) EUROPÄISCHE PATENTANMELDUNG

(43) Veröffentlichungstag:
04.11.1998 Patentblatt 1998/45

(51) Int. Cl.⁶: H02M 7/10

(21) Anmeldenummer: 98201335.1

(22) Anmeldetag: 27.04.1998

(84) Benannte Vertragsstaaten:
AT BE CH CY DE DK ES FI FR GB GR IE IT LI LU
MC NL PT SE
Benannte Erstreckungsstaaten:
AL LT LV MK RO SI

(30) Priorität: 02.05.1997 DE 19718656

(71) Anmelder:
• Philips Patentverwaltung GmbH
22335 Hamburg (DE)
Benannte Vertragsstaaten:
DE

• Koninklijke Philips Electronics N.V.
5621 BA Eindhoven (NL)
Benannte Vertragsstaaten:
FR GB

(72) Erfinder: Raets, Hubert
Röntgenstrasse 24, 22335 Hamburg (DE)

(74) Vertreter:
Hartmann, Heinrich, Dipl.-Ing. et al
Philips Patentverwaltung GmbH,
Röntgenstrasse 24
22335 Hamburg (DE)

(54) Hochspannnungsgenerator mit einer Hochspannungseinheit

(57) Die Erfindung betrifft einen Hochspannungsgenerator mit einer Hochspannungseinheit (1) und mit einer weiteren Spannungserzeugungseinheit (2) zur Erzeugung von DC-Hochspannungen ($U_{F1}$, $U_{F2}$), wobei die Spannungserzeugungseinheit (2) eine Einstelleinheit (3) zur Einstellung einer DC-Hochspannung ($U_{F1}$, $U_{F2}$) in einem Spannungseinstellbereich zwischen einer unteren und einer oberen Grenzspannung aufweist. Um die Spannungsfestigkeit der Einstelleinheit (3) so niedrig wie möglich wählen zu können und die Impedanz der Spannungserzeugungseinheit (2) zu erniedrigen, ist erfindungsgemäß vorgesehen, an den einen Anschlußpunkt (3B) der Einstelleinheit (3) eine zwischen 100% und 200% der oberen Grenzspannung liegende Gleichspannung und an den anderen Anschlußpunkt (3A) der Einstelleinheit (3) eine zwischen 50% und 100% der unteren Grenzspannung liegende Gleichspannung anzulegen. Die Erfindung betrifft auch ein Bildwiedergabegerät mit einer mindestens eine Fokuselektrode aufweisenden Bildwiedergaberöhre und einem derartigen Hochspannungsgenerator.

Fig.1

EP 0 875 985 A2

**Beschreibung**

Die Erfindung betrifft einen Hochspannungsgenerator mit einer Hochspannungseinheit zur Erzeugung einer Ausgangs-DC-Hochspannung und mit einer Spannungserzeugungseinheit zur Erzeugung mindestens einer weiteren, kleineren DC-Hochspannung, wobei der Spannungserzeugungseinheit aus der Hochspannungseinheit eine Gleichspannung zugeführt wird und wobei die Spannungserzeugungseinheit eine Einstelleinheit zur Einstellung der weiteren DC-Hochspannung in einem Spannungseinstellbereich zwischen einer unteren und einer oberen Grenzspannung aufweist.

Ein derartiger Hochspannungsgenerator ist aus der US-PS 4,788,591 bekannt. Mittels eines Dioden-Split-Transformators wird dort eine Ausgangs-DC-Hochspannung zur Versorgung der Anode einer Bildwiedergaberöhre erzeugt. Mittels einer zwei Potentiometer umfassenden Einstelleinheit werden zwei Spannungen erzeugt, die zur Fokussierung der Elektronen in der Bildwiedergaberohre dienen. Mittels der Potentiometer sind diese Spannungen einstellbar in einem Einstellbereich zwischen einer unteren und einer oberen Grenzspannung, die bei einer Bildwiedergaberöhre im allgemeinen 20% bzw. 29% der Ausgangs-DC-Hochspannung betragen. Eines der in Serie geschalteten Potentiometer ist an einem Anschlußpunkt der Hochspannungseinheit angeschlossen, an dem eine Gleichspannung anliegt. Der Fußpunkt des zweiten Potentiometers ist an einem im allgemeinen als Bezugspotential bei einer Bildwiedergaberöhre dienenden Gleichspannungspotential von 210 V angeschlossen.

Die Abmessungen und der Preis einer Spannungserzeugungseinheit, in der einstellbare DC-Hochspannungen, beispielsweise zur Fokussierung von Elektronen bei einer Röhre, insbesondere einer Bildwiedergaberöhre, erzeugt werden, werden im wesentlichen durch die erforderliche Spannungsfestigkeit und die Verlustleistung der Einstelleinheit, die bei der bekannten Anordnung zwei Potentiometer aufweist, bestimmt. Bei einer Bildwiedergaberöhre, bei der die Ausgangs-DC-Hochspannung beispielsweise 25 kV und die untere und obere Grenzspannung damit etwa 5 kV bzw. 7,25 kV betragen, muß die Einstelleinheit eine große Spannungsfestigkeit aufweisen. Bei der bekannten Anordnung, bei der zwei in Serie geschaltete Potentiometer zwischen einem Hochspannungspotential der Hochspannungseinheit und einer als Bezugspotential dienenden Niederspannungspotential anliegen, müssen die Potentiometer eine hohe Spannungsfestigkeit aufweisen, was zu hohen Verlustleistungen, hohen Preisen und großen Abmessungen der Potentiometer führt.

Der Erfindung liegt deshalb die Aufgabe zugrunde, einen Hochspannungsgenerator der eingangs genannten Art zu verbessern, insbesondere einen Hochspannungsgenerator mit geringen Kosten, geringen Abmessungen und hohem Wirkungsgrad anzugeben.

Diese Aufgabe wird ausgehend von dem eingangs genannten Hochspannungsgenerator dadurch gelöst, daß Mittel vorgesehen sind zur Versorgung der Einstelleinheit an einem Anschlußpunkt mit einer zwischen 100% und 200% der oberen Grenzspannung liegenden Gleichspannung und an einem weiteren Anschlußpunkt mit einer zwischen 50% und 100% der unteren Grenzspannung liegenden Gleichspannung und daß die Mittel mindestens eine Verbindung mit einem Gleichspannungspunkt der Hochspannungseinheit umfassen, an dem eine zwischen 50% der unteren Grenzspannung und 200% der oberen Grenzspannung liegende Gleichspannung anliegt.

Der Erfindung liegt dabei die Erkenntnis zugrunde, daß die Einstelleinheit nicht notwendigerweise an einem Anschlußpunkt mit einem als Bezugspotential dienenden Niedervoltpotential (z.B. Masse) angeschlossen sein muß. Die Einstelleinheit kann bei der erfindungsgemäßen Anordnung eine deutlich geringere Spannungsfestigkeit als bei der bekannten Anordnung aufweisen, da über der Einstelleinheit eine deutlich geringere Spannungsdifferenz anliegt. Die Spannungserzeugungseinheit weist auch eine niedrige Impedanz auf, wodurch Änderungen der DC-Hochspannungen, hervorgerufen durch Änderungen von Stromgrößen, möglichst klein sind. Bei einer Benutzung der DC-Hochspannungen zur Fokussierung der Elektronen bei einer Bildwiedergaberöhre bewirkt dies eine äußerst stabil bleibende Fokussierung. Je näher die an dem einen Anschlußpunkt anliegende Gleichspannung bei 100% der oberen Grenzspannung und die an dem anderen Anschlußpunkt anliegende Gleichspannung bei 100% der unteren Grenzspannung, desto geringer kann die Spannungsfestigkeit der Einstelleinheit ausfallen und desto vorteilhafter wirkt sich die Erfindung aus.

Eine Weiterbildung des erfindungsgemäßen Hochspannungsgenerators sieht vor, daß der Anschlußpunkt mit einem Gleichspannungspunkt der Hochspannungseinheit verbunden ist, an dem eine zwischen 100% und 200% der oberen Grenzspannung liegende Gleichspannung anliegt und daß der weitere Anschlußpunkt mit einem weiteren Gleichspannungspunkt der Hochspannungseinheit verbunden ist, an dem eine zwischen 50% und 100% der unteren Grenzspannung liegende Gleichspannung anliegt. Mit einfachen Mitteln wird somit erreicht, daß über der Einstelleinheit eine geringe Spannungsdifferenz anliegt. Je nach Anzahl der Verstärkungsstufen der Hochspannungseinheit können geeignete Gleichspannungspunkte der Hochspannungseinheit ausgewählt werden, an denen die Einstelleinheit angeschlossen wird.

In einer Ausgestaltung ist vorgesehen, daß der Hochspannungsgenerator einen Transformator mit einer ersten Sekundärwicklung zur Erzeugung der Eingangsspannung der Hochspannungseinheit aufweist, daß der Transformator eine zweite Sekundärwicklung mit einer nachgeschalteten Gleichrichterschaltung aufweist, daß die Ausgangsanschlüsse der Gleichrichterschaltung mit je einem der Anschlußpunkte der Einstelleinheit verbunden sind und daß einer der Anschlußpunkte der Einstelleinheit mit einem Gleichspannungspunkt der Hochspannungseinheit verbunden ist, an dem eine zwischen 50% und 100% der unteren Grenzspannung oder zwischen 100% und 200% der oberen Grenzspannung liegende Gleichspannung anliegt. Diese Ausgestaltung ist besonders geeignet, wenn der Hochspannungseinheit eine Gleichspannung entnehmbar ist, die möglichst genau der oberen oder der unteren Grenzspannung entspricht, aber keine weitere Gleichspannung, die der anderen Grenzspannung entspricht. Diese wird dann mittels der zweiten Sekundärwicklung des Transformators erzeugt, so daß über der Einstelleinheit nur die maximal notwendige Spannungsdifferenz anliegt.

Eine alternative Ausgestaltung sieht vor, daß der Hochspannungsgenerator einen Transformator mit einer ersten Sekundärwicklung zur Erzeugung der Eingangsspannung der Hochspannungseinheit aufweist, daß der Transformator eine zweite Sekundärwicklung aufweist, daß einem ersten Anschlußpunkt und einem mittleren Anschlußpunkt der Sekundärwicklung eine erste Gleichrichterschaltung nachgeschaltet ist, deren erster Ausgangsanschluß mit einem ersten Anschlußpunkt der Einstelleinheit verbunden ist und deren zweiter Ausgangsanschluß mit einem Gleichspannungspunkt der Hochspannungseinheit verbunden ist, an dem eine im Spannungseinstellbereich liegende Gleichspannung anliegt, und daß einem zweiten Anschlußpunkt und dem mittleren Anschlußpunkt der Sekundärwicklung eine zweite Gleichrichterschaltung nachgeschaltet ist, deren erster Ausgangsanschluß mit dem zweiten Anschlußpunkt der Einstelleinheit verbunden ist und deren zweiter Ausgangsanschluß mit demselben Gleichspannungspunkt der Hochspannungseinheit verbunden ist. Diese Ausgestaltung ist besonders vorteilhaft, wenn der Hochspannungseinheit eine Gleichspannung entnehmbar ist, die im Spannungseinstellbereich liegt, aber keine Gleichspannungen, die genau gleich der unteren oder oberen Grenzspannung sind. Aus der im Spannungseinstellbereich liegenden, der Hochspannungseinheit entnommenen Gleichspannung werden bei dieser Ausgestaltung zwei Spannungspotentiale abgeleitet, die der oberen bzw. unteren Grenzspannung entsprechen, so daß über der Einstelleinheit wiederum nur die maximal notwendige Spannungsdifferenz anliegt.

In einer Weiterbildung der Erfindung ist vorgesehen, daß einer der Anschlußpunkte der Einstelleinheit mit einem Gleichspannungspunkt der Hochspannungseinheit verbunden ist, an dem eine zwischen 50% und 100% der unteren Grenzspannung oder zwischen 100% und 200% der oberen Grenzspannung liegende Gleichspannung anliegt und daß die Mittel eine Spannungsvervielfacherschaltung, insbesondere eine Hochspannungs-Kaskaden-Multiplikatorschaltung aufweisen zur Erzeugung einer Gleichspannung aus der Eingangsspannung der Hochspannungseinheit zur Versorgung der Einstelleinheit am anderen Anschlußpunkt. Diese Lösung eignet sich besonders dann, wenn der Hochspannungseinheit eine Gleichspannung entnehmbar ist, die genau der oberen oder unteren Grenzspannung entspricht. Durch die Wahl des Verstärkungsfaktors der Spannungsvervielfacherschaltung wird dann eine Gleichspannung für die Einstelleinheit erzeugt, die genau der anderen Grenzspannung entspricht, die nicht der Hochspannungseinheit entnehmbar ist. Über der Einstelleinheit liegt auch bei dieser Weiterbildung nur die maximal notwendige Spannungsdifferenz an. Dadurch kann im übrigen die weiter oben beschriebene Ausgestaltung des Transformators mit einer zweiten Sekundärwicklung vermieden werden.

Eine bevorzugte Weiterbildung sieht vor, daß die Einstelleinheit zwei Potentiometer zur Einstellung jeweils einer DC-Hochspannung aufweist. Dies ist die einfachste und kostengünstigste Möglichkeit zur Realisierung der Einstelleinheit. Es besteht jedoch auch die Möglichkeit, die Einstelleinheit bzw. die Funktionen von Potentiometern durch andere schaltungstechnische Mittel zu realisieren.

Eine vorteilhafte Ausgestaltung sieht vor, daß die Hochspannungseinheit eine Kaskaden-Hochspannungs-Multiplikatorschaltung oder eine Dioden-Split-Transformatorschaltung umfaßt. Vor allem bei Bildwiedergaberöhren wird die Hochspannungseinheit eines Hochspannungsgenerators auf diese Weise realisiert. Die Anzahl der Verstärkungsstufen einer derartigen Hochspannungseinheit spielt dabei für den Erfindungsgedanken keine Rolle.

In einer Ausgestaltung sind Mittel vorgesehen zur Ableitung einer weiteren DC-Spannung aus einer zur Erzeugung der Eingangsspannung der Hochspannungseinheit verwendeten Wechselspannung. Diese Mittel können beispielsweise ein Potentiometer und ein zusätzlicher Anschluß an der Sekundärwicklung des Transformators sein, der eine Wechselspannung in die Eingangsspannung der Hochspannungseinheit hochtransformiert. Das Potentiometer kann auch an einer Verstärkungsstufe einer zusätzlichen Hochspannungs-Kaskaden-Multiplikatorschaltung zur Erzeugung einer Gleichspannung für die Einstelleinheit angeschlossen sein.

Die Erfindung betrifft auch ein Bildwiedergabegerät mit einer mindestens eine Fokuselektrode aufweisenden Bildwiedergaberöhre und mit einem Hochspannungsgenerator mit einer Hochspannungseinheit zur Erzeugung einer Ausgangs-DC-Hochspannung und mit einer Fokuseinheit zur Erzeugung mindestens einer Fokusspannung, wobei der Fokuseinheit aus der Hochspannungseinheit eine Gleichspannung zugeführt wird und wobei die Fokuseinheit eine Einstelleinheit zur Einstellung der Fokusspannung in einem Spannungseinstellbereich zwischen einer unteren und einer oberen Grenzspannung aufweist, die dadurch gekennzeichnet ist, daß Mittel vorgesehen sind zur Versorgung der Einstelleinheit an einem Anschlußpunkt mit einer zwischen 100% und 200% der oberen Grenzspannung liegenden Gleichspannung und an einem weiteren Anschlußpunkt mit einer zwischen 50% und 100% der unteren Grenzspannung liegenden Gleichspannung und daß die Mittel mindestens eine Verbindung mit einem Gleichspannungspunkt der Hochspannungseinheit umfassen, an dem eine zwischen 50% der unteren Grenzspannung und 200% der oberen Grenzspannung liegende Gleichspannung anliegt. Durch die Erfindung ist die Fokuseinheit einfach und kostengünstig zu realisieren. Die geringe Impedanz der Fokuseinheit führt außerdem zu geringen Abmessungen, einem höheren Wirkungungsgrad und letztlich einer sehr stabilen Fokussierung.

Vorteilhafte Ausgestaltungen des Bildwiedergabegeräts ergeben sich aus den Unteransprüchen.
Die Erfindung wird nachfolgend anhand der Zeichnung näher erläutert. Es zeigen:

Fig. 1   ein Schaltbild einer ersten Ausführungsform eines erfindungsgemäßen Hochspannungsgenerators mit einer Bildwiedergaberöhre,

Fig. 2   ein Schaltbild einer zweiten Ausführungsform eines erfindungsgemäßen Hochspannungsgenerators,

Fig. 3   ein Schaltbild einer dritten Ausführungsform eines erfindungsgemäßen Hochspannungsgenerators,

Fig. 4   ein Schaltbild einer vierten Ausführungsform eines erfindungsgemäßen Hochspannungsgenerators und

Fig. 5   ein Schaltbild eines erfindungsgemäßen Hochspannungsgenerators mit einem Dioden-Split-Transformator.

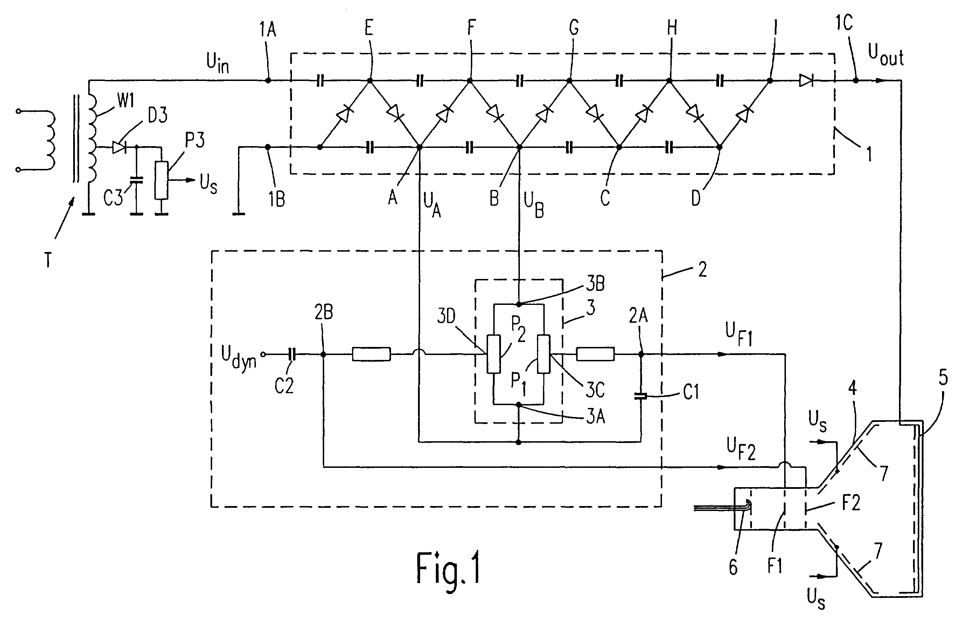

In Fig. 1 ist ein Schaltbild einer ersten Ausführungsform eines erfindungsgemäßen Hochspannungsgenerators gezeigt. Die Hochspannungseinheit 1 umfaßt eine Kaskaden-Hochspannungs-Multiplikatorschaltung mit zehn Verstärkungsstufen, die aus einer eingangs an den Eingängen 1A, 1B anliegenden symmetrischen Wechselspannung $U_{in}$ eine am Ausgang 1C anliegende DC-Hochspannung $U_{out}$ erzeugt, die um den Faktor zehn größer ist als die Amplitude der Eingangsspannung $U_{in}$. Die symmetrische Eingangswechselspannung $U_{in}$ kann wie gezeigt die Spannung über der Sekundärwicklung W1 des Transformators T eines (nicht gezeigten) serienparallel-resonanten, frequenzvariablen Konverters sein. Die Ausgangsgleichspannung $U_{out}$ der Hochspannungseinheit 1, die beispielsweise 25 kV (gegenüber Masse) beträgt, dient zur Versorgung der Anode 5 einer Bildwiedergaberöhre 4, um die aus der Kathode 6 emittierten Elektronen zu beschleunigen.
An den Gleichspannungspunkten A, B, C, D der Hochspannungseinheit 1 liegt jeweils eine DC-Hochspannung an, die 20% (Punkt A), 40% (B), 60% (C) bzw. 80% (D) der Ausgangsspannung $U_{out}$ (gegenüber Masse) beträgt. An den gegenüberliegenden Wechselspannungspunkten E, F, G, H, I der Hochspannungseinheit 1 liegen dagegen jeweils Wechselspannungen an, deren Amplituden genauso groß sind wie die Amplitude der Eingangsspannung $U_{in}$, denen allerdings ein unterschiedlicher Gleispannungs-Offset, z.B. von 10% (bei Punkt E) der Ausgangsspannung $U_{out}$ überlagert ist.

Zur Erzeugung zweier Fokusspannungen $U_{F1}$, $U_{F2}$ zur Versorgung der beiden Fokuselektroden F1, F2 der Bildwiedergaberöhre 4 ist eine Fokuseinheit 2 vorgesehen. Diese weist eine Einstelleinheit 3 auf, die mittels zweier Potentiometer P1, P2 die Einstellung der Fokusspannungen $U_{F1}$, $U_{F2}$ im Einstellbereich ermöglicht. Bei einer Bildwiedergaberöhre müssen die Gleichspannungen $U_{F1}$ und $U_{F2}$ etwa zwischen 20% (= untere Grenzspannung) und 29% (= obere Grenzspannung) der Anodenspannung $U_{out}$ der Bildwiedergaberöhre 4 einstellbar sein. Ein erster Anschlußpunkt 3A der Einstelleinheit 3 ist mit dem Gleichspannungspunkt A der Hochspannungseinheit 1 verbunden (also zwischen der zweiten und vierten Verstärkungsstufe), an dem die Gleichspannung $U_A = 0,2 * U_{out}$ (= 100% der unteren Grenzspannung) anliegt. Der zweite Anschlußpunkt 3B der Einstelleinheit 3 ist mit dem Gleichspannungspunkt B der Hochspannungseinheit 1 verbunden (zwischen der vierten und sechsten Verstärkungsstufe), an dem die Gleichspannung $U_B = 0,4 * U_{out}$ (= 138% der oberen Grenzspannung) anliegt. Am einstellbaren Ausgangsanschluß 3C des Potentiometers P1 wird über einen Widerstand die DC-Fokusspannung $U_{F1}$ zur Einstellung der horizontalen Fokuskorrektur bei der Bildwiedergaberöhre 4 abgegriffen, wobei zwischen den Anschlüssen 2A und 3A ein Glättungskondensator zur Verringerung der Welligkeit der Fokusspannung $U_{F1}$ anliegt. Am einstellbaren Ausgangsanschluß 3D des Potentiometers P2 wird der Gleichspannungsanteil für die Fokusspannung $U_{F2}$ über einen Widerstand abgegriffen, dem noch ein Wechselspannungsanteil $U_{dyn}$ über einen Kondensator C2 am Anschluß 2B zur Optimierung der vertikalen Fokussierung bei der Bildwiedergaberöhre 4 überlagert wird.

An der Sekundärwicklung W1 des Transformators T wird über eine Einweg-Gleichrichterschaltung aus einer Diode D3 und einem Kondensator C3 an einem Potentiometer P3 eine einstellbare Schirmspannung $U_S$ abgegriffen, die an weitere Elektronenfokussierungsmittel, beispielsweise Ablenkplatten 7 der Bildwiedergaberöhre 4 angelegt wird.

Beim erfindungsgemäßen Hochspannungsgenerator liegt über den Potentiometem P1 und P2 nur eine Spannungsdifferenz von $0,2 * U_{out}$ (also z.B. 5kV bei $U_{out}$ = 25 kV) an. Dadurch können die erforderliche Spannungsfestigkeit der Potentiometer P1, P2 deutlich gegenüber bekannten Ausführungen verringert und deren Abmessungen deutlich verkleinert werden. Gleichzeitig sind die Verluste in den Potentiometern P1, P2 bedeutend geringer, da diese Verluste etwa proportional dem Quadrat der Spannung über den Potentiometern P1, P2 sind. Auch die Impedanz der Fokuseinheit 2 ist deutlich geringer als bei bekannten Anordnungen. Dadurch wird erreicht, daß Änderungen der Fokusspannungen $U_{F1}$, $U_{F2}$, die durch Änderungen des Fokusstromes hervorgerufen werden können, sehr klein sind, so daß auch die Fokussierung sehr stabil bleibt. Insgesamt ist die gesamte Fokuseinheit 2 kleiner und billiger als bekannte Ausführungen.

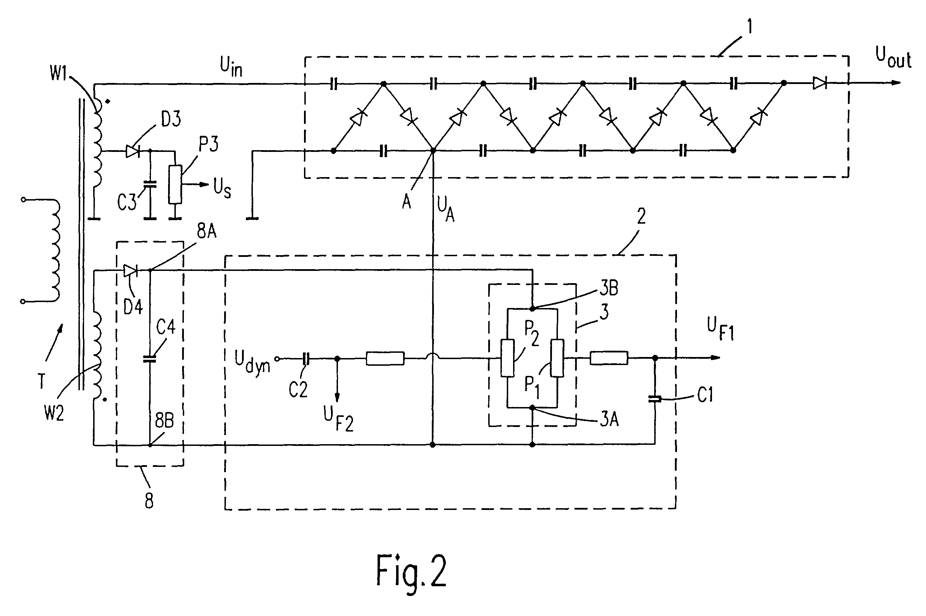

Eine weitere Ausführungsform eines erfindungsgemäßen Hochspannungsgenerators ist in Fig. 2 gezeigt. Anders als bei der in Fig. 1 gezeigten Ausführungsform wird die am zweiten Anschlußpunkt 3B der Einstelleinheit 3 angeschlossene Gleichspannung nicht der Hochspannungseinheit 1 entnommen, sondern separat erzeugt. Dazu weist der Transformator T eine zweite Sekundärwicklung W2 auf, die eine an der Primärwicklung des Transformators T anliegende Spannung in eine Hochspannung transformiert. Diese wird mit der aus der Diode D4 und dem Kondensator C4 bestehenden Gleichrichterschaltung 8 gleichgerichtet, so daß am Anschlußpunkt 8A eine DC-Hochspannung anliegt zur Versorgung des Anschlußpunktes 3B der Einstelleinheit 3. Der Anschlußpunkt 8B ist vorteilhafterweise mit dem Gleichspannungspunkt A (und damit auch mit dem Anschlußpunkt 3A) verbunden.

Durch Wahl des Übersetzungsverhältnisses des Transformators T (durch Wahl der Anzahl der Windungen der Sekundärwicklung W2) kann die zwischen den Anschlußpunkten 8A und 8B anliegende Spannung so eingestellt werden, daß über den Potentiometern P1, P2 nur die maximal notwendige Spannungsdifferenz anliegt. Beispielsweise kann das Übersetzungsverhältnis so gewählt werden, daß am Anschlußpunkt 8A eine Spannung von 0,29 * $U_{out}$ (gegenüber Masse) anliegt. Am Anschlußpunkt 8B liegt eine Spannung von 0,2 * $U_{out}$ (gegenüber Masse) an. Über den Potentiometern P1 und P2 liegt dann die kleinstmögliche Spannungsdifferenz von 0,09*$U_{out}$ an.

Die Anschlüsse an der Sekundärwicklung 2 werden bevorzugt so vorgenommen, daß die daran abgegriffene Spannung um 180° phasenverschoben ist gegenüber der an der Sekundärwicklung W1 abgegriffenen Spannung, was durch den Punkt am oberen Ende neben W1 bzw. am unteren Ende neben W2. Dadurch wird erreicht, daß die Welligkeit der am Gleichspannungspunkt A anliegenden Spannung $U_A$ durch die gegenphasige Welligkeit am Anschlußpunkt 8A kompensiert wird. Durch Wahl der Größe der Kapazität C4 kann die Welligkeit am Anschlußpunkt 8A gleich groß der Welligkeit am Gleichspannungspunkt A eingestellt und damit die Welligkeit der Fokusspannungen $U_{F1}$, $U_{F2}$ minimiert werden. Der Kapazitätswert des Kondersators C1, der durch Filterwirkung sonst ebenfalls für eine welligkeitsarme Fokusspannung $U_{F1}$ sorgt, kann im Gegenzug verringert werden.

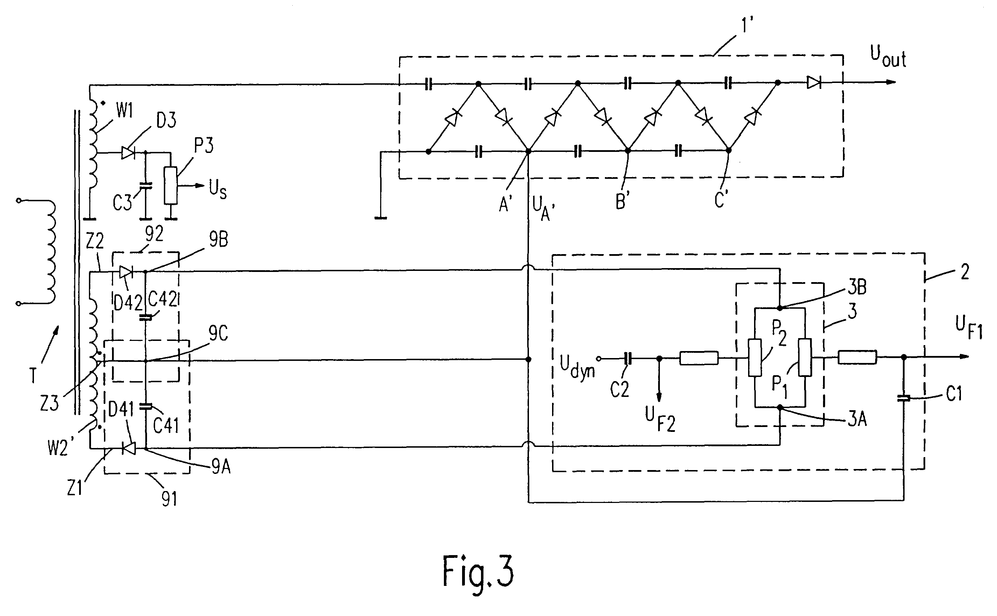

Eine dritte Ausführungsform eines erfindungsgemäßen Hochspannungsgenerators zeigt Fig. 3. Die Hochspannungseinheit 1' ist hier eine Verachtfacherkaskade. Die Spannung $U_{A'}$ am Gleichspannungspunkt A' beträgt hierbei 0,25 * $U_{out}$ und liegt damit fast mitten im Einstellbereich. Zur Erzeugung der erforderlichen Spannung für die Einstelleinheit 3 weist der Transformator T eine Sekundärwicklung W2' mit drei Anschlußpunkten Z1, Z2, Z3 auf, denen zwei Einweg-Gleichrichterschaltungen 91, 92 nachgeschaltet sind. Zwischen den Anschlußpunkten 9A und 9C, an dem die Gleichspannung $U_{A'}$ anliegt, wird aus der an den Abgriffen Z1 und Z3 abgegriffenen Spannung eine Gleichspannung durch Gleichrichtung mittels der Diode D41 und des Kondensators C41 erzeugt, die gleich der Spannungsdifferenz der niedrigsten einzustellenden Fokusspannung und der Spannung $U_{A'}$ ist. Dabei ist das Spannungspotential am Anschlußpunkt 9A, der mit dem Anschlußpunkt 3A der Einstelleinheit 3 verbunden ist, negativ gegenüber dem Spannungspotential am Anschlußpunkt 9C. Entsprechend wird zwischen den Anschlußpunkten 9B und 9C eine Spannung erzeugt, die gleich der Spannungsdifferenz der größten einzustellenden Fokusspannung und der Gleichspannung $U_{A'}$ ist. Dabei ist das Spannungspotential am Anschlußpunkt 9B, der mit dem Anschlußpunkt 3B der Einstelleinheit 3 verbunden ist, positiv gegenüber dem Spannungspotential am Anschlußpunkt 9C. Über den Potentiometern P1, P2 liegt hier ebenfalls nur die zwischen den Anschlußpunkten 9A und 9B erzeugte Spannung, die der Differenz zwischen der minimal und der maximal einzustellenden Fokusspannung beträgt. Die Spannung über dem Kondensator C1 beträgt hierbei maximal dem einzustellenden Fokusspannungsbereich, wobei meist eine kleinere Spannung anliegen wird.

Durch geeignete Wahl der Anschlüsse an den Sekundärwicklungen W1 und W2' (angedeutet durch die Punkte neben den Sekundärwicklungen W1, W2') kann wiederum wie bei der in Fig. 2 gezeigten Ausführungsform ein Welligkeitsausgleich durch Phasenverschiebung erreicht werden. Dadurch kann der Kapazitätswert des Kondensators C1 verringert werden.

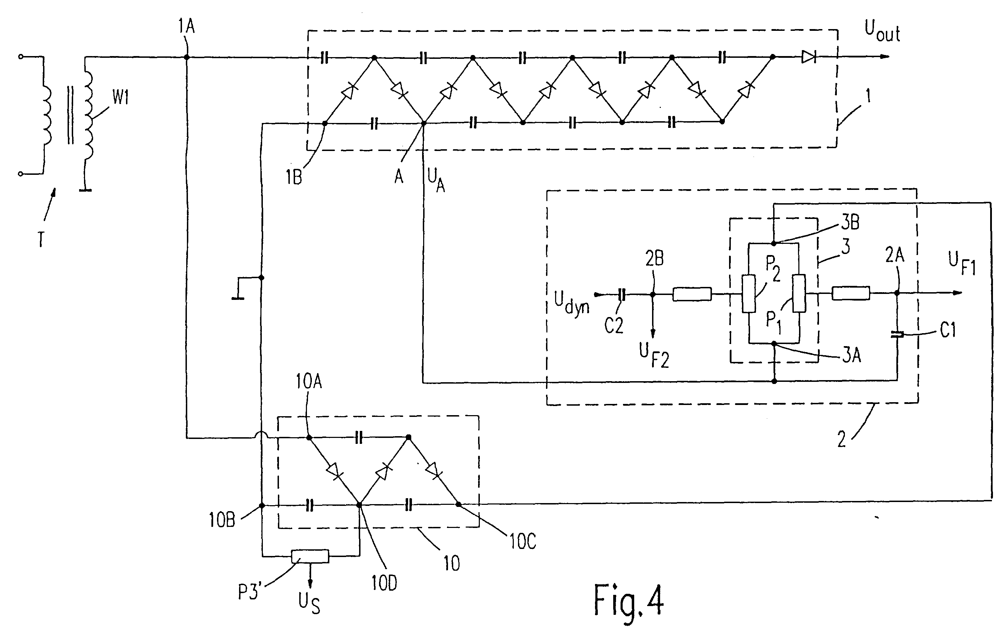

Eine alternative Möglichkeit zur Erzeugung einer geeigneten Spannung für den Anschlußpunkt 3B der Einstelleinheit 3 ist in Fig. 4 gezeigt. Der Eingangsanschluß 3A ist wiederum mit dem Gleichspannungsanschluß A einer Verzehnfacherkaskade 1 verbunden. Zur Erzeugung der am Anschlußpunkt 3B anliegenden Spannung ist eine separate Verdreifacherkaskade 10 vorgesehen, die aus der an den Eingangsanschlüssen 1A, 1B der Verzehnfacherkaskade 1 anliegenden Wechselspannung einen um den Faktor drei größere Gleichspannung am Ausgang 10C erzeugt. Über den Potentiometern P1, P2 liegt damit nur eine Spannung von 10% der Ausgangsspannung $U_{out}$ der Verzehnfacherkaskade 1 an. Durch geeignete Dimensionierung der Verdreifacherkaskade 10 kann deren Innenwiderstand so gewählt werden, daß darüber eine Spannung von 0,01 * $U_{out}$ abfällt, so daß über den Potentiometern P1, P2 nur die maximal notwendige Spannung von 0,09 * $U_{out}$ anliegt.

Bei dieser Ausführungsform ist keine zusätzliche Sekundärwicklung des Transformators T wie bei den in Fig. 2 und 3 gezeigten Ausführungsformen erforderlich. Dadurch kann der Transformator T wesentlich einfacher und damit günstiger ausgeführt und zudem besser optimiert werden. Die Schirmspannung $U_S$ kann hier mittels eines Potentiometers P3' zwischen den Anschlußpunkten 10B und 10D der Verdreifacherkaskade 10 abgegriffen werden, wodurch eine aufwendige Anzapfung der Sekundärwicklung W1 des Transformators T entfällt.

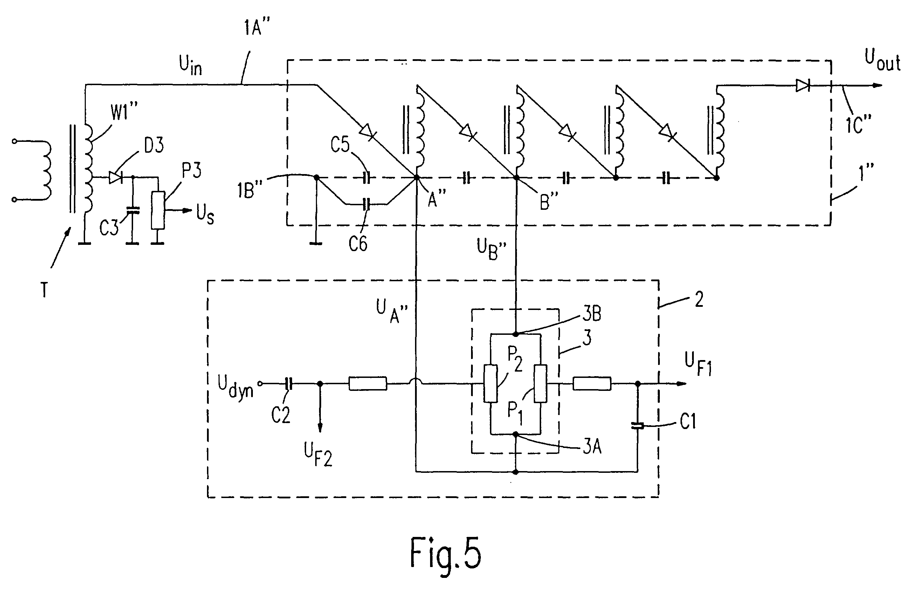

In Fig. 5 ist ein erfindungsgemäßer Hochspannungsgenerator gezeigt, bei dem die Hochspannungseinheit 1" einen fünfstufigen Dioden-Split-Transformator zur Erzeugung der DC-Hochspannung $U_{out}$ umfaßt. Dieser erzeugt ebenfalls aus der eingangs anliegenden Wechselspannung $U_{in}$ einen um den Faktor zehn größere Gleichspannung $U_{out}$. An den Gleichspannungspunkten A", der mit dem Anschlußpunkt 3A verbunden ist (also zwischen der ersten und zweiten Verstärkungsstufe), bzw. B", der mit dem Anschlußpunkt 3B verbunden ist (zwischen der zweiten und dritten Verstärkungsstufe), liegt ebenfalls eine Gleichspannung $U_{A"} = 0{,}2 * U_{out}$ bzw. $U_{B"} = 0{,}4 * U_{out}$ an. Eine Glättung der Fokusspannung $U_{F1}$ erfolgt hier ebenfalls durch die Reihenschaltung der Kapazitäten C1 und C5. Die Kapazität C5 entspricht dabei der Lagenkapazität über der Sekundärwicklung W1" des Transformators T. Da bei einem Dioden-Split-Transformator die Lagenkapazität C5 oft kleiner oder etwa gleich der Kapazität C1 ist, kann zusätzlich ein Kondensator C6 parallel zu C5 geschaltet werden. In Reihe zur Kapazität C6 kann außerdem ein Widerstand zur Strombegrenzung geschaltet werden.

Die in den Figuren 2 bis 4 gezeigten Möglichkeiten zur Erzeugung der Spannung für die Anschlußpunkte 3A, 3B der Einstelleinheit 3 sind auch bei einem Dioden-Split-Transformator 1" der in Fig. 5 gezeigten Art anwendbar. Bei Verwendung einer zweiten Sekundärwicklung (W2, W2' in Fig. 2, 3) müssen deren Anschlüsse jedoch mit den Anschlüssen der ersten Sekundärwicklung W1 in Phase sein. Ein Welligkeitsausgleich ist nicht möglich. Außerdem kann wegen des geringen Kapazitätswertes der Lagenkapazität C5 zusätzlich noch eine Tiefpaßschaltung (z.B. ein Widerstand zwischen A" und 3A und ein Kondensator zwischen 3A und Masse) vorgesehen sein zur Unterdrückung der Welligkeit am Gleichspannungspunkt A".

Die Potentiometer P1, P2 der Einstelleinheit 3 können auch durch geeignete schaltungstechnische Mittel realisiert werden, beispielsweise eine Stromspiegelschaltung, eine RC-Tiefpaßschaltung, eine Flyback-Transformatorschaltung oder eine einstellbare Zehnerdiodenschaltung.

Die Erfindung ist grundsätzlich auch anwendbar bei Hochspannungsgeneratoren, deren Hochspannungseinheit mehr oder weniger Verstärkungsstufen als die gezeigten Ausführungsformen aufweisen oder bei denen überhaupt die DC-Hochspannung $U_{out}$ mit anderen Mitteln erzeugt wird.

**Patentansprüche**

1. Hochspannungsgenerator mit einer Hochspannungseinheit (1) zur Erzeugung einer Ausgangs-DC-Hochspannung ($U_{out}$) und mit einer Spannungserzeugungseinheit (2) zur Erzeugung mindestens einer weiteren, kleineren DC-Hochspannung ($U_{F1}$, $U_{F2}$), wobei der Spannungserzeugungseinheit (2) aus der Hochspannungseinheit (1) eine Gleichspannung zugeführt wird und wobei die Spannungserzeugungseinheit (2) eine Einstelleinheit (3) zur Einstellung der weiteren DC-Hochspannung ($U_{F1}$, $U_{F2}$) in einem Spannungseinstellbereich zwischen einer unteren und einer oberen Grenzspannung aufweist, dadurch gekennzeichnet, daß Mittel (1, 8, 91, 92, 10) vorgesehen sind zur Versorgung der Einstelleinheit (3) an einem Anschlußpunkt (3B) mit einer zwischen 100% und 200% der oberen Grenzspannung liegenden Gleichspannung und an einem weiteren Anschlußpunkt (3A) mit einer zwischen 50% und 100% der unteren Grenzspannung liegenden Gleichspannung und daß die Mittel (1, 8, 91, 92, 10) mindestens eine Verbindung mit einem Gleichspannungspunkt (A, B) der Hochspannungseinheit (1) umfassen, an dem eine zwischen 50% der unteren Grenzspannung und 200% der oberen Grenzspannung liegende Gleichspannung ($U_A$, $U_B$) anliegt.

2. Hochspannungsgenerator nach Anspruch 1, dadurch gekennzeichnet, daß der Anschlußpunkt (3B) mit einem Gleichspannungspunkt (B) der Hochspannungseinheit (1) verbunden ist, an dem eine zwischen 100% und 200% der oberen Grenzspannung liegende Gleichspannung ($U_B$) anliegt und daß der weitere Anschlußpunkt (3A) mit einem weiteren Gleichspannungspunkt (A) der Hochspannungseinheit (1) verbunden ist, an dem eine zwischen 50% und 100% der unteren Grenzspannung liegende Gleichspannung ($U_A$) anliegt.

3. Hochspannungsgenerator nach Anspruch 1, dadurch gekennzeichnet, daß der Hochspannungsgenerator einen Transformator (T) mit einer ersten Sekundärwicklung (W1) zur Erzeugung der Eingangsspannung ($U_{in}$) der Hochspannungseinheit (1) aufweist, daß der Transformator (T) eine zweite Sekundärwicklung (W2) mit einer nachgeschalteten Gleichrichterschaltung (8) aufweist, daß die Ausgangsanschlüsse (8A, 8B) der Gleichrichterschaltung (8) mit je einem der Anschlußpunkte (3A, 3B) der Einstelleinheit (3) verbunden sind und daß einer der Anschlußpunkte (3A) der Einstelleinheit (3) mit einem Gleichspannungspunkt (A) der Hochspannungseinheit (1) verbunden ist, an dem eine zwischen 50% und 100% der unteren Grenzspannung oder zwischen 100% und 200% der oberen Grenzspannung liegende Gleichspannung ($U_A$) anliegt.

4. Hochspannungsgenerator nach Anspruch 1, dadurch gekennzeichnet, daß der Hochspannungsgenerator einen Transformator (T) mit einer ersten Sekundärwicklung (W1) zur Erzeugung der Eingangsspannung ($U_{in}$) der Hochspannungseinheit (1') aufweist, daß der Transformator (T) eine zweite Sekundärwicklung (W2') aufweist, daß einem ersten Anschlußpunkt (Z1) und einem mittleren Anschlußpunkt (Z3) der Sekundärwicklung (W2') eine erste Gleichrichterschaltung (91) nachgeschaltet ist, deren erster Ausgangsanschluß (9A) mit einem ersten Anschlußpunkt (3A) der Einstelleinheit (3) verbunden ist und deren zweiter Ausgangsanschluß (9C) mit einem Gleichspannungspunkt (A') der Hochspannungseinheit (1') verbunden ist, an dem eine im Spannungseinstellbereich liegende Gleichspannung ($U_{A'}$) anliegt, und daß einem zweiten Anschlußpunkt (Z2) und dem mittleren Anschlußpunkt (Z3) der Sekundärwicklung (W2') eine zweite Gleichrichterschaltung (92) nachgeschaltet ist, deren erster Ausgangsanschluß (9B) mit dem zweiten Anschlußpunkt (3B) der Einstelleinheit (3) verbunden ist und deren zweiter Ausgangsanschluß (9C) mit demselben Gleichspannungspunkt (A') der Hochspannungseinheit (1') verbunden ist.

5. Hochspannungsgenerator nach Anspruch 1, dadurch gekennzeichnet, daß einer der Anschlußpunkte (3A) der Einstelleinheit (3) mit einem Gleichspannungspunkt (A) der Hochspannungseinheit (1) verbunden ist, an dem eine zwischen 50% und 100% der unteren Grenzspannung oder zwischen 100% und 200% der oberen Grenzspannung liegende Gleichspannung ($U_A$) anliegt und daß die Mittel eine Spannungsvervielfacherschaltung (10), insbesondere eine Hochspannungs-Kaskaden-Multiplikatorschaltung aufweisen zur Erzeugung einer Gleichspannung aus der Eingangsspannung der Hochspannungseinheit (1) zur Versorgung der Einstelleinheit (3) am anderen Anschlußpunkt (3B).

6. Hochspannungsgenerator nach einem der vorhergehenden Ansprüche, dadurch gekennzeichnet, daß die Einstelleinheit (3) zwei Potentiometer (P1, P2) zur Einstellung jeweils einer DC-Hochspannung ($U_{F1}$, $U_{F2}$) aufweist.

7. Hochspannungsgenerator nach einem der vorhergehenden Ansprüche, dadurch gekennzeichnet, daß die Hochspannungseinheit (1, 1', 1") eine Kaskaden-Hochspannungs-Multiplikatorschaltung (1, 1') oder eine Dioden-Split-Transformatorschaltung (1") umfaßt.

8. Hochspannungsgenerator nach einem der vorhergehenden Ansprüche, dadurch gekennzeichnet, daß Mittel (P3, W1) vorgesehen sind zur Ableitung einer weiteren DC-Spannung ($U_S$) aus einer Niedervolt-Wechselspannung, insbesondere aus einer zur Erzeugung der Eingangsspannung der Hochspannungseinheit (1) verwendeten Wechselspannung.

9. Bildwiedergabegerät mit einer mindestens eine Fokuselektrode (F1, F2) aufweisenden Bildwiedergaberöhre (4) und mit einem Hochspannungsgenerator mit einer Hochspannungseinheit (1) zur Erzeugung einer Ausgangs-DC-Hochspannung ($U_{out}$) und mit einer Fokuseinheit (2) zur Erzeugung mindestens einer Fokusspannung ($U_{F1}$, $U_{F2}$), wobei der Fokuseinheit (2) aus der Hochspannungseinheit (1) eine Gleichspannung zugeführt wird und wobei die Fokuseinheit (2) eine Einstelleinheit (3) zur Einstellung der Fokusspannung ($U_{F1}$, $U_{F2}$) in einem Spannungseinstellbereich zwischen einer unteren und einer oberen Grenzspannung aufweist, dadurch gekennzeichnet, daß Mittel (1, 8, 91, 92, 10) vorgesehen sind zur Versorgung der Einstelleinheit (3) an einem Anschlußpunkt (3B) mit einer zwischen 100% und 200% der oberen Grenzspannung liegenden Gleichspannung und an einem weiteren Anschlußpunkt (3A) mit einer zwischen 50% und 100% der unteren Grenzspannung liegenden Gleichspannung und daß die Mittel (1, 8, 91, 92, 10) mindestens eine Verbindung mit einem Gleichspannungspunkt (A, B) der Hochspannungseinheit (1) umfassen, an dem eine zwischen 50% der unteren Grenzspannung und 200% der oberen Grenzspannung liegende Gleichspannung ($U_A$, $U_B$) anliegt.

10. Bildwiedergabegerät nach Anspruch 9, dadurch gekennzeichnet, daß die Hochspannungseinheit (2) eine zehnstufige Kaskaden-Multiplikatorschaltung (1) oder eine fünfstufige Dioden-Split-Transformatorschaltung (1") umfaßt, daß ein Anschlußpunkt (3A) der Einstelleinheit (3) mit einem Gleichspannungspunkt (A, A") zwischen der zweiten und vierten Verstärkungsstufe der Kaskaden-Multiplikatorschaltung (1) bzw. zwischen der ersten und zweiten Verstärkungsstufe der Dioden-Split-Transformatorschaltung (1") verbunden ist.

11. Bildwiedergabegerät nach Anspruch 10,

dadurch gekennzeichnet, daß der weitere Anschlußpunkt (3B) der Einstelleinheit (3) mit einem Gleichspannungspunkt (B, B") zwischen der vierten und sechsten Verstärkungsstufe der Kaskaden-Multiplikatorschaltung (1) bzw. zwischen der zweiten und dritten Verstärkungsstufe der Dioden-Split-Transformatorschaltung (1") verbunden ist.

12. Bildwiedergabegerät nach einem der Ansprüche 9 bis 11,
dadurch gekennzeichnet, daß die untere Grenzspannung etwa 20% und die obere Grenzspannung etwa 29% der Ausgangs-DC-Hochspannung ($U_{out}$) betragen.

Fig.1

Fig.2

Fig.3

Fig.4

Fig.5